# EUROPEAN PATENT APPLICATION

(11) **EP 4 836 638 A1**
(43) Date of publication of application: **04.11.2026**
(21) Application number: 25793159.2
(22) Date of filing: 09.01.2025
(51) Int. Cl.: H10F 19/00

(54) **SOLAR CELL AND PHOTOVOLTAIC MODULE**

(30) Priority: 26.04.2024 CN 202420895917 U; 29.07.2024 CN 202411028463
(71) Applicant: Zhejiang Aiko Solar Energy Technology Co., Ltd., Yiwu, Jinhua Zhejiang 322000 (CN); Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Jianjun, Jinhua, Zhejiang 322000 (CN); TAN, Lixiang, Jinhua, Zhejiang 322000 (CN); YANG, Xinqiang, Jinhua, Zhejiang 322000 (CN); ZHENG, Yan, Jinhua, Zhejiang 322000 (CN); CHEN, Gang, Jinhua, Zhejiang 322000 (CN)
(74) Representative: EP&C
(86) International application number: PCT/CN2025/071615
(87) International publication number: WO 2025/222961

(57) **Abstract**

The present disclosure is applicable to the technical field of solar power generation, and provides a solar cell and a photovoltaic module. The solar cell includes a silicon wafer and fingers disposed on the silicon wafer, wherein the fingers include first fingers and second fingers alternately distributed in a first direction; the silicon wafer has a first edge, a second edge, a third edge and a fourth edge, a first beveled edge is connected with the first edge and the third edge, a first interconnect is adjacent to the first beveled edge, the first interconnect is connected with the first fingers or the second fingers, the distance from the first beveled edge to an intersection point between the first edge and the third edge is less than or equal to 2.5 mm, and the number of first fingers or second fingers connected with the first interconnect is less than or equal to four. By means of making the first beveled edge very small, the first interconnect located at the first beveled edge is shorter, and only less than or equal to four first fingers or second fingers can be connected, so that the light-receiving area of a cell is ensured as much as possible, and the conversion efficiency of the cell is ensured.

## Description

### Cross-Reference to Related Application

The present disclosure claims the priority of Chinese Patent Application 202420895917.1, filed in the China National Intellectual Property Administration on April 26, 2024, and entitled "Busbar-Free Back-Contact Solar Cell, Cell module and Photovoltaic System", and the priority of Chinese Patent Application 202411028463.9, filed in the China National Intellectual Property Administration on July 29, 2024, and entitled "Solar Cell and Photovoltaic module", the entire contents of which are herein incorporated by reference.

### Technical Field

The present disclosure belongs to the technical field of solar power generation, and particularly relates to a solar cell and a photovoltaic module.

### Background

A solar cell is an apparatus for directly converting light energy into electric energy via a photoelectric effect, crystalline silicon cells use silicon wafers as substrates and are divided into P-type cells and N-type cells according to differences between the silicon wafers, the two types of cells have no essential difference in power generation principles and both rely on PN junctions to separate photogenerated carriers.

During production and preparation processes of the solar cell, a wafer having a suitable size and shape is obtained by performing cutting and smoothing processes on a ingot, and a qualified silicon wafer can be obtained after subsequent etching, polishing, cleaning, evaluating and other processes. For the silicon wafer, the size of a front surface (a light-receiving surface) of the silicon wafer plays a crucial role in the power generation conversion efficiency, the usage of a square silicon wafer is an optimal choice, and when a square matrix is formed by using square silicon wafers, gaps between adjacent silicon wafers are very small or even there is no gap, thereby ensuring the power generation efficiency.

Chamfering is performed on the existing silicon wafer, the edge of the chamfered silicon wafer has lower central stress, so that the silicon wafer is firmer. However, the chamfer of the existing silicon wafer is usually large, resulting in a reduced area of the light-receiving surface of the silicon wafer, and thus affecting the power generation efficiency.

### Summary

Embodiments of the present disclosure provide a solar cell and a photovoltaic module, so as to solve the problem of the power generation efficiency being affected by a small area of a light-receiving surface of an existing solar cell.

The embodiments of the present disclosure are implemented as follows: a solar cell, including:
a silicon wafer, wherein several fingers are disposed on the silicon wafer, and the fingers include first fingers and second fingers alternately distributed in a first direction;
the silicon wafer has:
   a first edge and a second edge disposed opposite to each other in a second direction, and a third edge and a fourth edge disposed opposite to each other in the first direction, the second direction being perpendicular to the first direction;
   a first beveled edge for connecting the first edge and the third edge; and
   a first interconnect disposed adjacent to the first beveled edge, wherein the first interconnect is connected with at least one first finger or at least one second finger; and
   an intersection point between the first beveled edge and the first edge is a first intersection point, an intersection point between the first beveled edge and the third edge is a second intersection point, the distance between the first intersection point and the second intersection point is less than or equal to 2.5 mm, and the number of first fingers or second fingers connected with the first interconnect is less than or equal to four.

In some embodiments, the first beveled edge is a straight line or an arc.

In some embodiments, the first interconnect is not parallel to the first beveled edge.

In some embodiments, the first interconnect includes a first connection portion and a second connection portion, and the width of the first connection portion is less than the width of the second connection portion.

In some embodiments, the first connection portion is connected with the second connection portion, and the first connection portion is an diagonal line.

In some embodiments, the second connection portion and the first connection portion are connected by one finger.

In some embodiments, the second connection portion and the first connection portion are parallel to the first direction.

In some embodiments, a ratio of the width of the finger to the width of the first interconnect is 1: 1.2 to 1: 2.

In some embodiments, the ratio of the width of the finger to the width of the first interconnect is 1: 1.6 to 1: 1.8.

In some embodiments, the distance between the first intersection point and the second intersection point is 0.7 mm to 2.5 mm.

In some embodiments, the distance between the first intersection point and the second intersection point is 1.2 mm to 1.6 mm.

In some embodiments, the silicon wafer includes a second beveled edge for connecting the first edge and the fourth edge;
a second interconnect adjacent to the second beveled edge is disposed on the silicon wafer, and the second interconnect is connected with at least one first finger or at least one second finger; and
the first interconnect and the second interconnect are connected to fingers having the same polarity.

In some embodiments, the silicon wafer includes a third beveled edge for connecting the second edge and the third edge;
a third interconnect adjacent to the third beveled edge is disposed on the silicon wafer, and the third interconnect is connected with at least one first finger or at least one second finger; and
the first interconnect and the third interconnect are connected to fingers having opposite polarities.

In some embodiments, an included angle between the first interconnect and the second direction is greater than an included angle between the third interconnect and the second direction.

In some embodiments, the first interconnect is connected to the first finger, and in the second direction, the distance between the end point of the second finger adjacent to the first interconnect and the first interconnect is less than the distance between the first interconnect and the first beveled edge; or
the first interconnect is connected to the second finger, and in the second direction, the distance between the end point of the first finger adjacent to the first interconnect and the first interconnect is less than the distance between the first interconnect and the first beveled edge.

In some embodiments, in the second direction, the distance between the first interconnect and the first beveled edge is greater than the distance between the third interconnect and the third beveled edge.

In some embodiments, the first interconnect is connected to the first finger, and the third interconnect is connected to the second finger; and
in the second direction, the width of the first interconnect is less than the width of the third interconnect.

In some embodiments, the line width of the second finger is greater than the line width of the first finger.

In a second aspect, the present disclosure further provides a photovoltaic module, including the above solar cell.

The present disclosure has the beneficial effects that the solar cell of the present disclosure includes the silicon wafer and the fingers (an intermediate layer can be disposed between the fingers and the silicon wafer) disposed on the silicon wafer, the fingers include the first fingers and the second fingers alternately distributed in the first direction, the silicon wafer has the first fine gate of the first edge and the second edge disposed opposite to each other in the second direction, and the third edge and the fourth edge disposed opposite to each other in the first direction, the second direction is perpendicular to the first direction, the first beveled edge is connected with the first edge and the third edge, the first interconnect is adjacent to the first beveled edge, the first interconnect is connected with the first fingers or the second fingers, the intersection point between the first beveled edge and the first edge is the first intersection point, the intersection point between the first beveled edge and the third edge is the second intersection point, the distance between the first intersection point and the second intersection point is less than or equal to 2.5 mm, and the number of first fingers or second fingers connected with the first interconnect is less than or equal to four. By means of the above settings, the first beveled edge can be made very small, so that the first interconnect located at the first beveled edge is shorter, and only less than or equal to four first fingers or second fingers can be connected, so that the light-receiving area of a cell is ensured as much as possible, and the conversion efficiency of the cell is ensured.

### Brief Description of the Drawings

Fig. 1 is a schematic diagram of modules of a photovoltaic system provided in an embodiment of the present disclosure;
Fig. 2 is a schematic diagram of modules of a cell module provided in an embodiment of the present disclosure;
Fig. 3 is a schematic diagram of a plane structure of a back surface of a solar cell provided in an embodiment of the present disclosure;
Fig. 4 is a partial enlarged schematic diagram of the solar cell in Fig. 3 at a first conductive contact structure;
Fig. 5 is another partial enlarged schematic diagram of the solar cell in Fig. 3 at the first conductive contact structure;
Fig. 6 is still another partial enlarged schematic diagram of the solar cell in Fig. 3 at the first conductive contact structure;
Fig. 7 is yet another partial enlarged schematic diagram of the solar cell in Fig. 3 at the first conductive contact structure;
Fig. 8 is a partial enlarged schematic diagram of the solar cell in Fig. 3 at a second conductive contact structure;
Fig. 9 is another partial enlarged schematic diagram of the solar cell in Fig. 3 at the second conductive contact structure;
Fig. 10 is still another partial enlarged schematic diagram of the solar cell in Fig. 3 at the second conductive contact structure;
Fig. 11 is yet another partial enlarged schematic diagram of the solar cell in Fig. 3 at the second conductive contact structure;
Fig. 12 is a schematic diagram of another plane structure of the back surface of a solar cell provided in an embodiment of the present disclosure;
Fig. 13 is a schematic diagram of still another plane structure of a back surface of a solar cell provided in an embodiment of the present disclosure;
Fig. 14 is a schematic structural diagram of one embodiment of a solar cell provided in the present disclosure;
Fig. 15 is an enlarged schematic diagram of a portion A in Fig. 14;
Fig. 16 is an enlarged schematic diagram of a portion B in Fig. 14;
Fig. 17 is a schematic structural diagram of one embodiment of a solar cell provided in the present disclosure, in which a chamfer edge is arc-shaped;
Fig. 18 is a schematic structural diagram of one embodiment of a solar cell provided in the present disclosure, in which a chamfer edge is in a combined shape of an arc and a straight line;
Fig. 19 is a schematic structural diagram of one embodiment of a solar cell provided in the present disclosure, in which a interconnect is step-shaped;
Fig. 20 is a schematic diagram of a line width between a finger and a interconnect in one embodiment of a solar cell provided in the present disclosure;
Fig. 21 is an enlarged schematic diagram of a portion C in Fig. 14;
Fig. 22 is a schematic structural diagram of a first beveled edge in one embodiment of a solar cell provided in the present disclosure; and
Fig. 23 is a schematic structural diagram of a first beveled edge in one embodiment of a solar cell provided in the present disclosure.

### Detailed Description of the Embodiments

In order to make the objectives, technical solutions and advantages of the present disclosure clearer, the present disclosure will be further described in detail below in combination with the drawings and embodiments. Examples of the embodiments are shown in the drawings, wherein the same or similar reference signs represent the same or similar elements or elements with the same or similar functions throughout. The embodiments described below with reference to the drawings are exemplary and are merely used to explain the present disclosure, and cannot be construed as limitations to the present disclosure. In addition, it should be understood that specific embodiments described herein are only used to explain the present disclosure and are not used to limit the present disclosure.

In the description of the present disclosure, it should be understood that orientation or position relationships indicated by terms "length", "width", "upper", "lower", "left", "right", "horizontal", "top", "bottom" and the like are orientation or position relationships shown on the basis of the drawings, and are merely for the convenience of describing the present disclosure and simplifying the description, but do not indicate or imply that referred apparatuses or elements must have specific orientations or must be constructed and operated in specific orientations, and thus cannot be construed as limitations to the present disclosure.

In addition, the terms "first" and "second" are used for descriptive purposes only and cannot be understood as indicating or implying relative importance or implicitly indicating the number of indicated technical features. Therefore, features defined with "first" and "second" can explicitly or implicitly include one or more of the features. In the description of the present disclosure, "a plurality of" means two or more, unless explicitly defined otherwise.

In the description of the present disclosure, it should be noted that unless otherwise specified and limited explicitly, the terms "installed", "connected" and "connection" should be understood in a broad sense. For example, the connection can be a fixed connection, and can also be a detachable connection, or an integral connection; can be a mechanical connection, and can also be an electrical connection or mutual communication; and can be a direct connection, can be an indirect connection via an intermediate medium, and can also be internal communication between two elements or an interaction relationship between the two elements. For those ordinary skilled in the art, the specific meanings of the above terms in the present disclosure can be understood in specific situations.

In the present disclosure, unless otherwise specified ord limited explicitly, a first feature being "on" or "under" a second feature can include that the first feature is in direct contact with the second feature, or the first feature is not in direct contact with the second feature but is in contact with the second feature through an additional feature therebetween. Moreover, the first feature being "over", "above" and "on" the second feature includes that the first feature is directly above and obliquely above the second feature, or merely indicates that a horizontal height of the first feature is greater than that of the second feature. The first feature being "under", "below" and "beneath" the second feature includes that the first feature is directly below and obliquely below the second feature, or merely indicates that the horizontal height of the first feature is less than that of the second feature.

The following disclosure provides many different embodiments or examples to implement different structures of the present disclosure. In order to simplify the disclosure of the present disclosure, components and settings of specific examples are described below. Of course, they are merely examples, and are not intended to limit the present disclosure. In addition, the present disclosure can repeat reference numerals and/or reference letters in different examples, and this repetition is for the purpose of simplicity and clarity, and does not indicate the relationship between various embodiments and/or settings discussed. In addition, the present disclosure provides examples of various specific processes and materials, but those ordinary skilled in the art can be aware of applications of other processes and/or usage scenarios of other materials.

A solar cell of the present disclosure includes a silicon wafer and fingers (an interlayer can be disposed between the fingers and the silicon wafer) disposed on the silicon wafer, the fingers include first fingers and second fingers alternately distributed in a first direction, the silicon wafer has a first fine gate of the first edge and a second edge disposed opposite to each other in a second direction, and a third edge and a fourth edge disposed opposite to each other in the first direction, the second direction is perpendicular to the first direction, a first beveled edge is connected with the first edge and the third edge, a first interconnect is adjacent to the first beveled edge, the first interconnect is connected with the first fingers or the second fingers, an intersection point between the first beveled edge and the first edge is a first intersection point, an intersection point between the first beveled edge and the third edge is a second intersection point, the distance between the first intersection point and the second intersection point is less than or equal to 2.5 mm, and the number of first fingers or second fingers connected with the first interconnect is less than or equal to four. By the above settings, the first beveled edge can be made very small, so that the first interconnect located at the first beveled edge is shorter, and only less than or equal to four first fingers or second fingers can be connected, so that the light-receiving area of a cell is ensured as much as possible, and the conversion efficiency of the cell is ensured.

### Embodiment 1

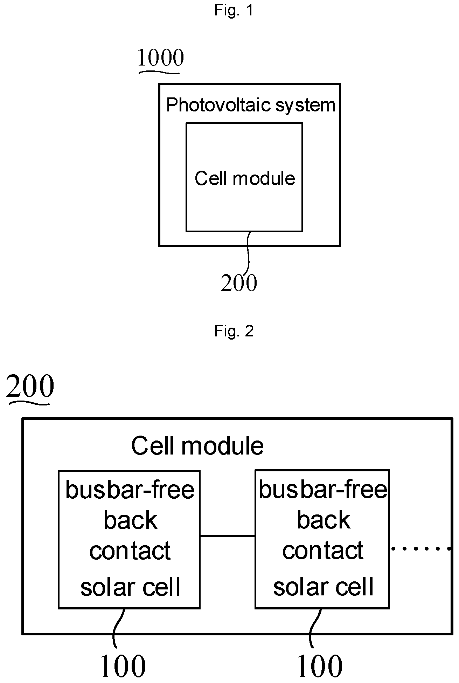

Referring to Fig. 1 to Fig. 2, a photovoltaic system 1000 in the embodiments of the present disclosure can include a cell module 200 in the embodiments of the present disclosure, the cell module 200 in the embodiments of the present disclosure can include several cell strings, and the cell string can include several busbar-free back contact solar cells 100 in the embodiments of the present disclosure. In the present disclosure, a plurality of busbar-free back contact solar cells 100 in the cell module 200 can be sequentially connected together in series via ribbons to form the cell strings. The cell strings in the cell module 200 can be connected in series, in parallel, or a serial-parallel combined manner to realize current collection and output, for example, the connection between the cell strings can be realized by a current collector.

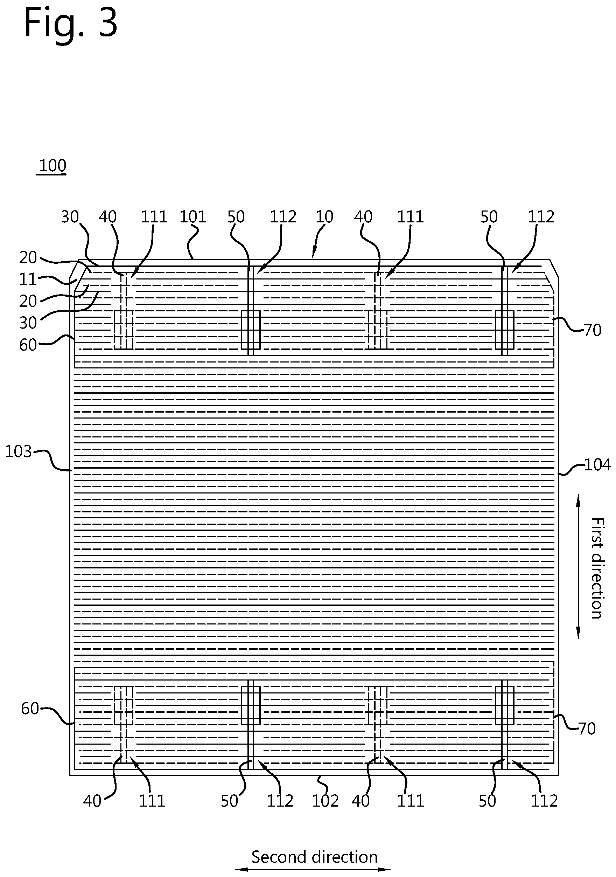

Referring to Fig. 3, the busbar-free back contact solar cell 100 in the embodiments of the present disclosure can include a silicon wafer 10, several first fingers 20, several second fingers 30, several first conductive contact structures 40, and several second conductive contact structures 50.

The silicon wafer 10 has a front surface and a back surface 11 which are opposite to each other, the back surface 11 has several first regions 111 and several second regions 112, the several first fingers 20 and the several second fingers 30 are disposed on the back surface 11 of the silicon wafer 10, the several first fingers 20 and the several second fingers 30 are sequentially and alternately arranged at intervals in a first direction, and the first fingers 20 and the second fingers 30 all extend in a second direction, and the second direction intersects with the first direction. Specifically, as shown in Fig. 3, the first direction and the second direction can be respectively a longitudinal direction and a transverse direction of the busbar-free back contact solar cell 100, of course, in other embodiments, the first direction and the second direction can also be other directions, for example, the two directions can be respectively diagonal directions of the silicon wafer 10, which is not specifically limited herein.

The first conductive contact structures 40 are disposed in the first regions 111, the first conductive contact structures 40 are connected with the several first fingers 20, and the second fingers 30 are disconnected at the first conductive contact structures 40. The second conductive contact structures 50 are disposed in the second regions 112, the second conductive contact structures 50 are connected with the several second fingers 30, and the first fingers 20 are disconnected at the second conductive contact structures 50.

In the busbar-free back contact solar cell 100, the cell module 200 and the photovoltaic system 1000 of the embodiments of the present disclosure, the back surface 11 of the silicon wafer 10 has the first regions 111 and the second regions 112, the first conductive contact structures 40 are disposed in the first regions 111 and are connected with the several first fingers 20, the second conductive contact structures 50 are disposed in the second regions 112 and are connected with the several second fingers 30, and the first conductive contact structures 40 and the second conductive contact structures 50 can be configured to form respective contact with a positive probe and a negative probe of a test device. In this way, by disposing the several first conductive contact structures 40 and the several second conductive contact structures 50, the area of the first conductive contact structures 40 and the second conductive contact structures 50 is greater than the area of a single first finger 20 and the area of a single second finger 30, and when tests such as hot spot and EL are performed on the busbar-free back contact solar cell 100, the positive probe and the negative probe of the test device can form stable contact with the first conductive contact structures 40 and the second conductive contact structures 50, thereby reducing the test difficulty and improving the test reliability and stability. Meanwhile, when a ribbon is subsequently soldered, the first conductive contact structures 40 and the second conductive contact structures 50 can serve as point locations soldered with the ribbon, and since the first conductive contact structures 40 and the second conductive contact structures 50 are respectively connected with the several first fingers 20 and the several second fingers 30, it is not necessary to dispose soldering spots or soldering layers on all the fingers during soldering, so that the usage of solder paste can be reduced.

Specifically, it can be understood that in the present disclosure, the back surface 11 of the silicon wafer 10 is provided with several first doped layers (not shown in Fig) and several second doped layers (not shown in Fig), the first doped layers and the second doped layers are respectively P-type doped layers and N-type doped layers, back-surface passivation layers (not shown in Fig) are disposed on the first doped layers and the second doped layers, the first fingers 20 are correspondingly disposed above the first doped layers and penetrate through the back-surface passivation layers to form ohmic contact with the first doped layers, and the second fingers 30 are correspondingly disposed on the second doped layers and penetrate through the back-surface passivation layers to form ohmic contact with the second doped layers.

Taking the hot spot test as an example, when the hot spot test is performed on the busbar-free back contact solar cell 100 of the present disclosure, the positive probe and the negative probe of the test device can respectively from stable contact with the first conductive contact structures 40 and the second conductive contact structures 50, and then the temperature at each position of the busbar-free back contact solar cell 100 is observed by simulating a scenario in which the busbar-free back contact solar cell 100 is shielded.

In some embodiments, the area of the first region 111 can be 5-60 mm2, that is, the area of an orthographic projection of the first conductive contact structure 40 on the back surface 11 can be 5-60 mm2.

Thus, by setting the area of the first region 111 within this reasonable range, it is possible to avoid the situation in which the first conductive contact structure 40 cannot form stable contact with the test probe due to an excessively small area of the first region 111, and it is also possible to avoid the situation in which the current collection efficiency is affected due to the fact that the area on the back surface 11 without metal fingers is relatively small due to an excessively large area of the first region 111.

Specifically, in such an embodiment, the area of the first region 111 can be, for example, 5 mm2, 10 mm2, 15 mm2, 20 mm2, 25 mm2, 30 mm2, 35 mm2, 40 mm2, 45 mm2, 50 mm2, 55 mm2, 60 mm2, or any numerical value between 5 mm2 and 60 mm2, which is not specifically limited herein.

In some embodiments, the area of the second region 112 can be 5-60 mm2, that is, the area of an orthographic projection of the second conductive contact structure 50 on the back surface 11 can be 5-60 mm2.

Thus, by setting the area of the second region 112 within this reasonable range, it is possible to avoid the situation in which the second conductive contact structure 50 cannot form stable contact with the test probe due to an excessively small area of the second region 112, and it is also possible to avoid the situation in which the current collection efficiency is affected due to the fact that the area on the back surface 11 without metal fingers is relatively small due to an excessively large area of the second region 112.

Specifically, in such an embodiment, the area of the second region 112 can be, for example, 5 mm2, 10 mm2, 15 mm2, 20 mm2, 25 mm2, 30 mm2, 35 mm2, 40 mm2, 45 mm2, 50 mm2, 55 mm2, 60 mm2, or any numerical value between 5 mm2 and 60 mm2, which is not specifically limited herein.

In some embodiments, both the first conductive contact structure 40 and the second conductive contact structure 50 can be contact pads, that is, soldering spots to be soldered with the ribbon.

Thus, the first conductive contact structure 40 and the second conductive contact structure 50 can also serve as soldering spots in contact with soldering while forming stable and reliable contact with the test probe, thereby reducing the number of soldering spots during subsequent soldering.

Referring to Fig. 3 to Fig. 5, in some embodiments, the first conductive contact structure 40 can include several first conductive interconnects 41 arranged at intervals in the first region 111 in the second direction, and the first conductive interconnects 41 are disposed to intersect with the several first fingers 20 and are connected with the several first fingers 20.

Thus, the test probe can form stable electrical contact just by forming contact, in the first region 111, with any first conductive interconnect 41 in a net structure, thereby improving the contact reliability.

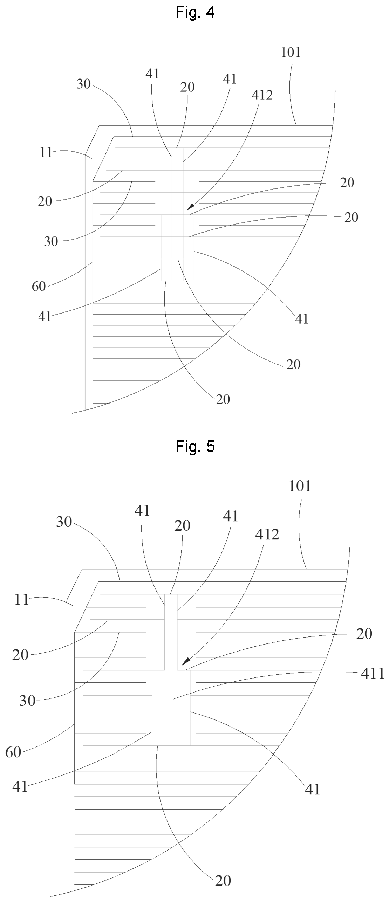

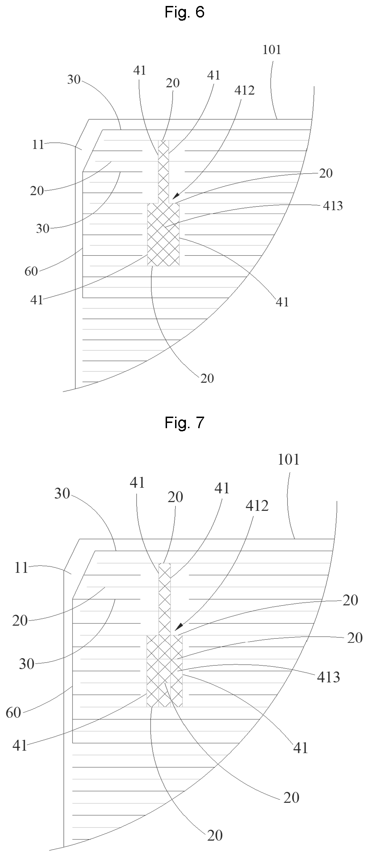

In some embodiments, as shown in Fig. 5, in such an embodiment, the several first conductive interconnects 41 and the several first fingers 20 form a first filling region 411 in an enclosing manner; or
as shown in Fig. 6, the several first conductive interconnects 41 intersect with the several first fingers 20 to form a first net structure 412.

Thus, the first conductive interconnects 41 and the several first fingers 20 form the first filling region 411 or the first net structure 412, and during testing, the test probe can form stable electrical contact just by forming contact with any first conductive interconnect 41 in the first region 111 or any first conductive interconnect 41 in the first net structure 412 and the first fingers 20, thereby improving the contact reliability.

In addition, as shown in Fig. 6 and Fig. 7, in some embodiments, in order to further improve the contact stability of the test probe, the first conductive contact structure 40 can further include a first conductive material 413 filled in adjacent first filling regions 411 or first net structures 412. In this way, the area of the first conductive contact structure 40 can be increased, so that the first conductive contact structure 40 can form more reliable and stable contact with the test probe during testing. Moreover, in such an embodiment, when the first conductive contact structure 40 serves as a soldering spot, the soldering stability can be improved.

Of course, in some embodiments, the first conductive contact structure 40 can also be not filled with the first conductive material 413, if the first conductive contact structure 40 is required to serve as the soldering spot, during subsequent soldering, the first filling region 411 or the first net structure 412 can be filled with a conductive soldering material such as a soldering flux, so as to be soldered with the ribbon.

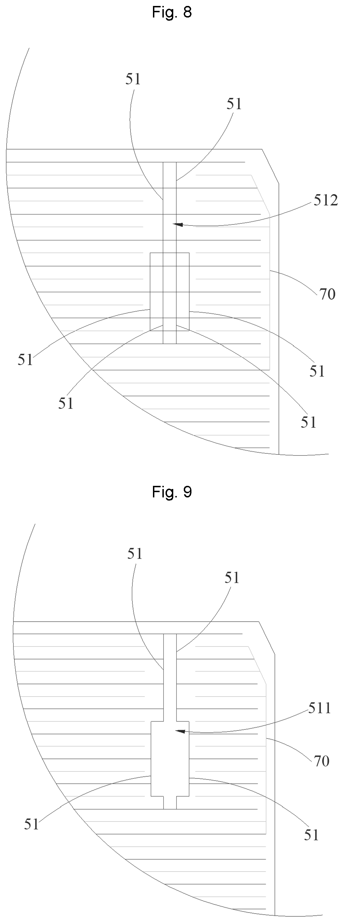

Referring to Fig. 8 and Fig. 9, in some embodiments, the second conductive contact structure 50 includes several second conductive interconnects 51 arranged at intervals in the second region 112 in the second direction, and the second conductive interconnects 51 are disposed to intersect with the several second fingers 30 and are connected with the several second fingers 30.

Thus, the test probe can form stable electrical contact just by forming contact, in the second region 112, with any second conductive interconnect 51 in the net structure, thereby improving the contact reliability.

In some embodiments, as shown in Fig. 9, in such an embodiment, the several second conductive interconnects 51 and the several second fingers 30 form a second filling region 511 in the enclosing manner; or
as shown in Fig. 8, the several second conductive interconnects 51 intersect with the several second fingers 30 to form a second net structure 512.

Thus, the second conductive interconnects 51 and the several second fingers 30 form the second filling region 511 or the second net structure 512, and during testing, the test probe can form stable electrical contact just by forming contact with any second conductive interconnect 51 in the second region 112 or any second conductive interconnect 51 in the second net structure 512 and the second fingers 30, thereby improving the contact reliability.

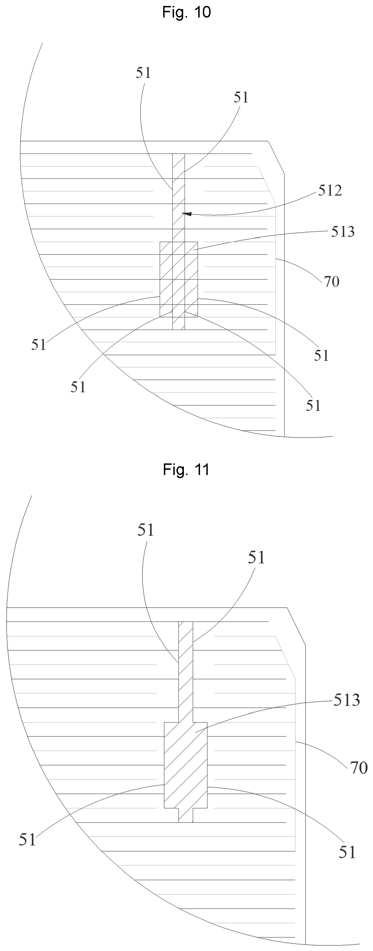

In addition, as shown in Fig. 10 and Fig. 11, in some embodiments, in order to further improve the contact stability of the test probe, the second conductive contact structure 50 can further include a second conductive material 513 filled in adjacent second filling regions 511 or second net structures 512. In this way, the area of the second conductive contact structure 50 can be increased, so that the second conductive contact structure 50 can form more reliable and stable contact with the test probe during testing. Moreover, in such an embodiment, when the second conductive contact structure 50 serves as a soldering spot, the soldering stability can be improved.

Of course, in some embodiments, the second conductive contact structure 50 can also be not filled with the second conductive material 513, if the second conductive contact structure 50 is required to serve as the soldering spot, during subsequent soldering, the second filling region 511 or the second net structure 512 can be filled with a conductive soldering material such as a soldering flux, so as to be soldered with the ribbon.

Referring to Fig. 3 to Fig. 5, in some embodiments, each first conductive contact structure 40 is correspondingly connected with 2-7 first fingers 20.

Thus, by such setting, the first conductive contact structure 40 can have a relatively large area, and when the first conductive contact structure 40 serves as a soldering spot, the soldering point locations of 2-7 ribbons can be reduced when the soldering spot is soldered, thereby reducing the usage of paste and improving the soldering reliability, and also avoiding a greater transmission loss caused by excessive first fingers 20 correspondingly connected with the first conductive contact structure 40.

Specifically, in such an embodiment, the number of first fingers 20 correspondingly connected with each first conductive contact structure 40 can be, for example, 2, 3, 4, 5, 6 and 7, for example, as shown in Fig. 3, the number of first fingers 20 correspondingly connected with each first conductive contact structure 40 is 7.

Referring to Fig. 3, Fig. 8 and Fig. 9, in some embodiments, each second conductive contact structure 50 is correspondingly connected with 2-7 second fingers 30.

Thus, by such setting, the second conductive contact structure 50 can have a relatively large area, and when the second conductive contact structure 50 serves as a soldering spot, the soldering point locations of 2-7 ribbons can be reduced when the soldering spot is soldered, thereby reducing the usage of paste and improving the soldering reliability, and also avoiding a greater transmission loss caused by excessive second fingers 30 correspondingly connected with the second conductive contact structure 50.

Specifically, in such an embodiment, the number of second fingers 30 correspondingly connected with each second conductive contact structure 50 can be, for example, 2, 3, 4, 5, 6 and 7, for example, as shown in Fig. 3, the number of second fingers 30 correspondingly connected with each second conductive contact structure 50 is 7.

As described above, in some embodiments, both the first conductive contact structure 40 and the second conductive contact structure 50 can be soldered with soldering spots, specifically, the first conductive contact structure 40 can be soldered with a ribbon which is configured to perform collect and output on the current collected by the first fingers 20, and the second conductive contact structure 50 can be soldered with a ribbon which is configured to perform collect and output on the current collected by the second fingers 30.

Thus, the first conductive contact structure 40 and the second conductive contact structure 50 can serve as the soldering spots of the ribbons while forming stable contact with the test probe, thereby multiplexing functions.

Specifically, in this case, the specific structures of the first conductive contact structure 40 and the second conductive contact structure 50 can be understood with reference to the above description.

Referring to Fig. 3, in some embodiments, the silicon wafer 10 has a first edge 101 and a second edge 102 in the first direction, and the first edge 101 and the second edge 102 each is provided with several first conductive contact structures 40 and several second conductive contact structures 50;
at the first edge 101, the first conductive contact structure 40 and the second conductive contact structure 50 are sequentially and alternately arranged at intervals in the second direction; and
at the second edge 102, the first conductive contact structure 40 and the second conductive contact structure 50 are also sequentially and alternately arranged at intervals in the second direction.

Thus, by disposing the first conductive contact structures 40 and the second conductive contact structures 50 on the edges of the silicon wafer 10, a contact with the test probe can be facilitated.

In some embodiments, referring to Fig. 3, in such an embodiment, the first conductive contact structure 40 located at the first edge 101 is connected with the first finger 20 closest to the first edge 101, and the second conductive contact structure 50 located at the first edge 101 is connected with the second finger 30 closest to the first edge 101; and/or
the first conductive contact structure 40 located at the second edge 102 is connected with the first finger 20 closest to the second edge 102, and the second conductive contact structure 50 located at the second edge 102 is connected with the second finger 30 closest to the second edge 102.

Thus, both the first conductive contact structure 40 and the second conductive contact structure 50 are disposed on the outermost edge position of the first edge 101 and the outermost edge position of the second edge 102, and when the first conductive contact structure 40 and the second conductive contact structure 50 serve as soldering spots, the first conductive contact structure 40 and the second conductive contact structure 50 can serve as start soldering spots and/or end soldering spots during soldering, thereby ensuring the soldering stability.

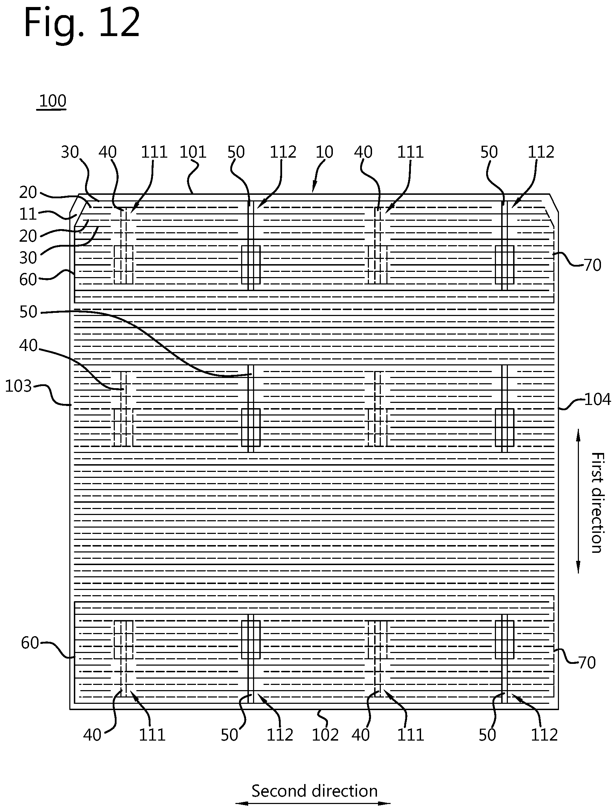

Referring to Fig. 3 and Fig. 12, in some embodiments, the first conductive contact structure 40 located on the first edge 101 is aligned with the first conductive contact structure 40 located on the second edge 102 in the first direction; and
the second conductive contact structure 50 located on the first edge 101 is aligned with the second conductive contact structure 50 located on the second edge 102 in the first direction.

Thus, the first conductive contact structure 40 on the first edge 101 is aligned with the first conductive contact structure 40 on the second edge 102, the second conductive contact structure 50 on the first edge 101 is aligned with the second conductive contact structure 50 on the second edge 102, the two aligned first conductive contact structures 40 can respectively serve as a start soldering spot and an end soldering spot during the soldering of the ribbon for collecting the current of the first fingers 20, and the two aligned second conductive contact structures 50 can respectively serve as a start soldering spot and an end soldering spot during the soldering of the ribbon for collecting the current of the second fingers 30, thereby ensuring the soldering reliability, and meanwhile there is no need to dispose additional start soldering spots and end soldering spots.

Referring to Fig. 12, in some embodiments, at least one first conductive contact structure 40 aligned with the first conductive contact structures 40 located on the first edge 101 and the first conductive contact structures 40 located on the second edge 102 is further disposed between the two first conductive contact structures 40 aligned in the first direction; and/or
at least one second conductive contact structure 50 aligned with the second conductive contact structures 50 located on the first edge 101 and the second conductive contact structures 50 located on the second edge 102 is further disposed between the two second conductive contact structures 50 aligned in the first direction.

Thus, by disposing at least one first conductive contact structure 40 between the two first conductive contact structures 40 aligned in the alignment direction, when the first conductive contact structures 40 serve as soldering spots, at least three first conductive contact structures 40 are soldered with the soldering spots to further ensure the soldering stability; and similarly, by disposing at least one second conductive contact structure 50 between the two second conductive contact structures 50 aligned in the alignment direction, when the second conductive contact structures 50 serve as soldering spots, at least three second conductive contact structures 50 are soldered with the soldering spots to further ensure the soldering stability.

Referring to Fig. 3 and Fig. 4, in some embodiments, the silicon wafer 10 further has a third edge 103 and a fourth edge 104 opposite to each other in the second direction, and a first edge busbar 60 is disposed at the third edge 103;
when the conductive contact structure closest to the third edge 103 in the first direction is the first conductive contact structure 40, the second finger 30 disconnected at the junction of the first edge busbar 60 and the first conductive contact structure 40 is located on a portion at the third edge 103 and at least one second finger 30 that is not disconnected at the first conductive contact structure 40; and
when the conductive contact structure closest to the third edge 103 in the first direction is the second conductive contact structure 50, the first finger 20 disconnected at the junction of the first edge busbar 60 and the second conductive contact structure 50 is located on a portion at the third edge 103 and at least one first finger 20 that is not disconnected at the first conductive contact structure 40.

Specifically, when the conductive contact structure closest to the third edge 103 in the first direction is the first conductive contact structure 40, and the first conductive contact structure 40 closest to the third edge 103 serves as a soldering spot soldered with the ribbon, since the second finger 30 needs to be disconnected at the first conductive contact structure 40, in this case, the current of the portion of the second finger 30 located between the first conductive contact structure 40 and the third edge 103 cannot be collected. In the present embodiment, by disposing the first edge busbar 60, the current collected by this portion of second finger 30 can be collected to the at least one second finger 30 that is not disconnected, thereby realizing the collection of the current of this portion of finger and reducing the efficiency loss.

When the conductive contact structure closest to the third edge 103 in the first direction is the second conductive contact structure 50, and the second conductive contact structure 50 closest to the third edge 103 serves as a soldering spot soldered with the ribbon, since the first finger 20 needs to be disconnected at the second conductive contact structure 50, in this case, the current of the portion of first finger 20 located between the second conductive contact structure 50 and the third edge 103 cannot be collected. In the present embodiment, by disposing the first edge busbar 60, the current collected by this portion of first finger 20 can be collected to the at least one first finger 20 that is not disconnected, thereby realizing the collection of the current of this portion of finger and reducing the efficiency loss.

Referring to Fig. 3 and Fig. 8, in some embodiments, a second edge busbar 70 is disposed at the fourth edge 104;
when the conductive contact structure closest to the fourth edge 104 in the first direction is the first conductive contact structure 40, the second finger 30 disconnected at the junction of the second edge busbar 70 and the first conductive contact structure 40 is located on a portion at the fourth edge and at least one second finger 30 that is not disconnected at the first conductive contact structure 40; and
when the conductive contact structure closest to the fourth edge 104 in the first direction is the second conductive contact structure 50, the first finger 20 disconnected at the junction of the second edge busbar 70 and the second conductive contact structure 50 is located on a portion at the fourth edge and at least one first finger 20 that is not disconnected at the first conductive contact structure 40.

Specifically, when the conductive contact structure closest to the fourth edge 104 in the first direction is the first conductive contact structure 40, and the first conductive contact structure 40 closest to the fourth edge 104 serves as a soldering spot soldered with the ribbon, since the second finger 30 needs to be disconnected at the first conductive contact structure 40, in this case, the current of the portion of second finger 30 located between the first conductive contact structure 40 and the third edge 103 cannot be collected. In the present embodiment, by disposing the second edge busbar 70, the current collected by this portion of second finger 30 can be collected to the at least one second finger 30 that is not disconnected, thereby realizing the collection of the current of this part of finger and reducing the efficiency loss.

When the conductive contact structure closest to the fourth edge 104 in the first direction is the second conductive contact structure 50, and the second conductive contact structure 50 closest to the fourth edge 104 serves as a soldering spot soldered with the ribbon, since the first finger 20 needs to be disconnected at the second conductive contact structure 50, in this case, the current of the portion of first finger 20 located between the second conductive contact structure 50 and the fourth edge 104 cannot be collected. In the present embodiment, by disposing the second edge busbar 70, the current collected by this portion of first finger 20 can be collected to the at least one first finger 20 that is not disconnected, thereby realizing the collection of the current of this portion of finger and reducing the efficiency loss.

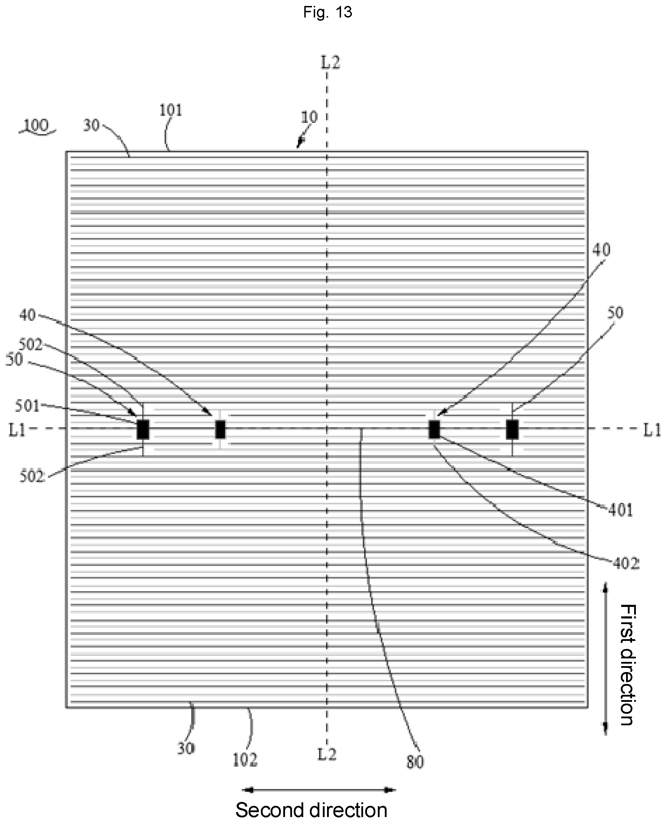

Referring to Fig. 13, in some embodiments, the silicon wafer 10 has a first center line L1 and a second center line L2 perpendicular to each other, the first center line L1 is parallel to the second direction, the second center line L2 is parallel to the first direction, the silicon wafer 10 is symmetrical with respect to the first center line L1 in the first direction, and the silicon wafer 10 is symmetrical with respect to the second center line L2 in the second direction;
the first conductive contact structure 40 and the second conductive contact structure 50 are both disposed on the first center line L1, and in the first direction, the portions of the first conductive contact structure 40 located on two sides of the first center line L 1 are symmetrically disposed with respect to the first center line L1, and the portions of the second conductive contact structure 50 located on the two sides of the first center line L1 are also symmetrically disposed with respect to the first center line L1;
wherein the first fingers 20 on the two sides of the first center line L1 are symmetrical with respect to the first center line L1, and the second fingers 30 on the two sides of the first center line L1 are also symmetrical with respect to the first center line L1; and
the first conductive contact structures 40 and the second conductive contact structures 50 are disposed on the two sides of the second center line L2, the first conductive contact structures 40 located on the two sides of the second center line L2 are symmetrically disposed with respect to the second center line L2, and the second conductive contact structures 50 located on the two sides of the second center line L2 are also symmetrically disposed with respect to the second center line L2.

Thus, rotational symmetry of the first conductive contact structures 40 and the second conductive contact structures 50 can be realized. In this way, in a manufacturing process, during the process of disposing the first fingers 20 and the second fingers 30 after the first conductive contact structures 40 are printed, the busbar-free back contact solar cell 100 can be randomly moved and exchanged without performing alignment and calibration.

Specifically, as shown in Fig. 13, in such an embodiment, the same number of first conductive contact structures 40 (e.g., 1, 2, or 3) are disposed on the two sides of the second center line L2, the first conductive contact structures 40 on the two sides are symmetrical with respect to the second center line L2, the same number of second conductive contact structures 50 are also disposed at the same time, and the second conductive contact structures 50 on the two sides are also symmetrical with respect to the second center line L2. Meanwhile, for each conductive contact structure, a center point thereof is located on the first center line L1, and the portions of each conductive contact structure located on the two sides of the first center line L1 are symmetrical with respect to the first center line L1.

In some embodiments, in such an embodiment, additional fingers can be not disposed at the first center line L1. Of course, in order to maximize the utilization of the area of the silicon wafer 10, a central finger 80 can also be disposed at the first center line L1, and the central finger 80 has the same polarity as the fingers (the first fingers 20 or the second fingers 30, the second fingers 30 shown in Fig. 13) closest to two opposite edges (i.e., the first edge 101 and the second edge 102) of the silicon wafer 10 in the first direction.

Thus, by disposing the central finger 80 having the same polarity as the fingers closest to the first edge 101 and the second edge 102, all the fingers on the two sides of a midline grid line can be symmetrical with respect to the central finger 80, thereby achieving the purpose of moving and exchanging the fingers during the process of disposing the fingers. It is not difficult to understand that, in such an embodiment, a doped layer corresponding to the polarity of the central finger 80 can be disposed below the central finger 80, and the central finger 80 penetrates through a passivation layer to form contact with the doped layer below, thereby improving the area utilization rate and improving the current collection capability.

Specifically, as shown in Fig. 13, when all the fingers closest to the first edge 101 and the second edge 102 are the second fingers 30, the central finger 80 is a grid line the same as the second finger 30, which is equivalent to that the first fingers 20 and the second fingers 30 are uniformly and alternately arranged at intervals on the silicon wafer 10, and all the fingers located on the two upper and lower edges in the first direction are the second fingers 30, there are N second fingers 30, then there are N-1 first fingers 20, and the extra second finger 30 is the central finger 80 coinciding with the first center line L1. Similarly, when all the fingers closest to the first edge 101 and the second edge 102 are the first fingers 20, the central finger 80 is a grid line having the same polarity as the first finger 30, which is not specifically repeated herein again.

Still referring to Fig. 13, in such an embodiment, the first conductive contact structure 40 can include a first contact pad 401 located on the first center line L1, and two first interconnects 402 connected with two ends of the first contact pad and extending in the first direction, the first interconnects 402 are connected with at least one first finger 20, the second conductive contact structure 50 can include a second contact pad 501 located on the first center line L1, and two second interconnects 502 connected with two ends of the second contact pad 501 and extending in the first direction, and the second interconnects 502 are connected with at least one second finger 30.

Thus, a stable contact with the probe can be realized by the contact pads, and then some fingers are connected by the interconnects, thereby realizing a stable test on electrical performance and hot spots.

In some embodiments, in such an embodiment, the width of the first interconnect 402 can be greater than the width of the first finger 20, the width of the second interconnect 502 is greater than the width of the second finger 30, the width of the first interconnect 402 and the width of the second interconnect 502 refer to the length of the first interconnect 402 and the length of the second interconnect 502 in the second direction, and the width of the first finger 20 and the width of the second finger 30 refer to the length of the first finger 20 and the length of the second finger 30 in the first direction.

### Embodiment 2

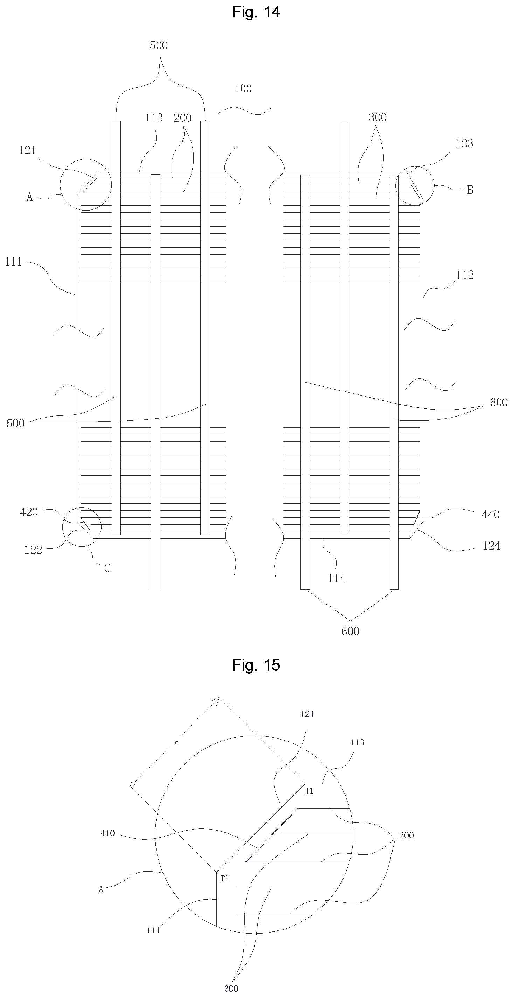

As shown in Fig. 14 to Fig. 23, an embodiment of the present disclosure provides a solar cell, including:
a silicon wafer 100, wherein several fingers are disposed on the silicon wafer 100, and the fingers include first fingers 200 and second fingers 300 alternately distributed in a first direction;
the silicon wafer 100 has:
   a first edge 111 and a second edge 112 disposed opposite to each other in a second direction, and a third edge 113 and a fourth edge 114 disposed opposite to each other in the first direction, the second direction being perpendicular to the first direction;
   a first beveled edge 121 for connecting the first edge 111 and the third edge 113; and
   a first interconnect 410 disposed adjacent to the first beveled edge 121, wherein the first interconnect 410 is connected with at least one first finger 200 or at least one second finger 300; and
   an intersection point between the first beveled edge 121 and the first edge 111 is a first intersection point J2, an intersection point between the first beveled edge 121 and the third edge 113 is a second intersection point J1, the distance between the first intersection point J2 and the second intersection point J1 is less than or equal to 2.5 mm, and the number of first fingers 200 or second fingers 300 connected with the first interconnect 410 is less than or equal to four.

During implementation, the silicon wafer 100, the first finger 200 and the second finger 300 can respectively refer to the silicon wafer 10, the first finger 20 and the second finger 30 in the above Embodiment 1, the silicon wafer 100 is a silicon substrate, the silicon substrate can be an N-type silicon wafer or a P-type silicon wafer, wherein the N-type silicon wafer is obtained by adding a pentavalent element (e.g., phosphorus, arsenic or bismuth, or the like) into intrinsic silicon, and the P-type silicon wafer is obtained by adding a trivalent element (e.g., boron, gallium or indium, or the like) into the intrinsic silicon, and no repeated description is given.

The silicon wafer 100 has a front surface and a back surface, wherein the front surface of the silicon wafer 100 corresponds to a light-receiving surface of the solar cell, and similarly, the back surface of the silicon wafer 100 corresponds to a backlight surface of the solar cell.

In some embodiments, the fingers can be disposed on the front surface or the back surface of the silicon wafer 100, wherein the fingers refer to metal fingers, including the first fingers 200 and the second fingers 300, and the first fingers 200 and the second fingers 300 are alternately disposed in the first direction. Exemplarily, it is taken as an example that the first direction is a vertical direction, the first fingers 200 and the second fingers 300 are sequentially and alternately distributed from top to bottom on the silicon wafer 100, one second finger 300 is disposed between two adjacent first fingers 200, and similarly, one first finger 200 is disposed between two adjacent second fingers 300, thereof no repeated description is given.

The silicon wafer 100 is in the shape of a sheet or a plate and thus has four edges, namely the third edge 113 and the fourth edge 114 disposed opposite to each other in the first direction, and the first edge 111 and the second edge 112 disposed opposite to each other in the second direction, and the second direction is perpendicular to the first direction.

Exemplarily, it is taken as an example that the first direction is the vertical direction, then the second direction is a horizontal direction, at this time, the first edge 111 and the second edge 112 can be regarded as a left edge and a right edge of the silicon wafer 100, and similarly, the third edge 113 and the fourth edge 114 can be regarded as an upper edge and a lower edge of the silicon wafer 100. In some other embodiments, when the first direction is the horizontal direction, the second direction is the vertical direction, at this time, the first edge 111 and the second edge 112 can be regarded as the upper edge and the lower edge of the silicon wafer 100, and similarly, the third edge 113 and the fourth edge 114 can be regarded as the left edge and the right edge of the silicon wafer 100, thereof no repeated description is given.

The silicon wafer 100 is provided with the first beveled edge 121, the first beveled edge 121 is connected with the first edge 111 and the third edge 113, the first interconnect 410 is disposed adjacent to the first beveled edge 121, the first interconnect 410 can be connected with the first fingers 200 or the second fingers 300, and meanwhile, since the distance between the first intersection point J2 and the second intersection point J1 is smaller than 2.5 mm, the number of first fingers 200 or second fingers 300, which can be connected with the first interconnect 410, is less than or equal to four by designing the first beveled edge 121 to be a chamfer region with a smaller range. Exemplarily, it is taken as an example that the first interconnect 410 is connected with the first fingers 200, the first interconnect 410 can be connected with four first fingers 200, or the first interconnect 410 can be connected with three first fingers 200, or the first interconnects 410 can be connected with two first fingers 200, or the first interconnects 410 can be connected with one first finger 200.

Optionally, the distance between the first intersection point J2 and the second intersection point J1 is less than or equal to 2.5 mm, for example, the distance between the first intersection point J2 and the second intersection point J1 can be designed to be 0.9 mm, 1.1 mm, 1.2 mm, 1.5 mm, 1.6 mm, 1.8 mm, 2.0 mm, 2.4 mm, or any numerical value between 0.7 mm to 2.5 mm, preferably, the distance between the first intersection point J2 and the second intersection point J1 is 1.2 mm to 1.6 mm, for example, a preset threshold value is 1.3 mm, 1.4 mm, 1.45 mm, 1.5 mm, or any numerical value between 1.2 mm to 1.6 mm, which is not limited.

In some possible embodiments, the silicon wafer 100 includes a second beveled edge 122, a third beveled edge 123 and a fourth beveled edge 124, wherein the second beveled edge 122 is connected with the first edge 111 and the fourth edge 114, the third beveled edge 123 is connected with the second edge 112 and the third edge 113, and the fourth beveled edge 124 is connected with the second edge 112 and the fourth edge 114.

The silicon wafer 100 is further provided with a second interconnect 420, a third interconnect 430 and a fourth interconnect 440, wherein the second interconnect 420 is adjacent to the second beveled edge 122, the third interconnect 430 is adjacent to the third beveled edge 123, the fourth interconnect 440 is adjacent to the fourth beveled edge 124, and the second interconnect 420, the third interconnect 430 and the fourth interconnect 440 each is connected with at least one first finger or at least one second finger.

During implementation, the first interconnect 410 and the second interconnect 420 are connected to fingers having the same polarity, the first interconnect 410 and the third interconnect 430 are connected to fingers having opposite polarities, for example, when the first interconnect 410 is connected with the first fingers 200, the second interconnect 420 is also connected with the first fingers 200, the third interconnect 430 is connected with the second fingers 300, and the fourth interconnect 430 is also connected with the second fingers 300.

It should be noted that the intersections between the first beveled edge 121 and the corresponding edges being J1 and J2 are examples of the embodiments of the present disclosure, rather than specifically limiting the present disclosure, and in some other embodiments, the second beveled edge 122, the third beveled edge 123 and the fourth beveled edge 124 can refer to the first beveled edge 121 described above, thereof no repeated description is given.

In some possible embodiments, it is taken as an example that the first interconnect 410 is connected with the first fingers 200, the first interconnect 410 can be connected with two first fingers 200, the third interconnect 430 is connected with one second finger 300, the second interconnect 420 is connected with the two first fingers 200, and the fourth interconnect 440 is connected with one second finger 300.

Optionally, the first interconnect 410 can be connected with three first fingers 200, the third interconnect 430 is connected with two second fingers 300, the second interconnect 420 is connected with three first fingers 200, and the fourth interconnect 440 is connected with two second fingers 300. Optionally, the first interconnect 410 can be connected with four first fingers 200, the third interconnect 430 is connected with three second fingers 300, the second interconnect 420 is connected with four first fingers 200, and the fourth interconnect 440 is connected with three second fingers 300.

It should be noted that the number of fingers connected with the interconnect at each beveled edge is an example of one embodiment of the present disclosure, rather than specifically limiting the present disclosure, and in some other embodiments, the number of fingers connected with the interconnect at each beveled edge can be set according to requirements, which is not limited.

The solar cell of the present disclosure includes the silicon wafer 100 and the fingers disposed on the silicon wafer 100, the fingers include the first fingers 200 and the second fingers 300 alternately distributed in the first direction, the silicon wafer 100 has the first fine gate of the first edge 111 and the second edge 112 disposed opposite to each other in the second direction, the third edge 113 and the fourth edge 114 disposed opposite to each other in the first direction, the second direction being perpendicular to the first direction, the first beveled edge 121 for connecting the first edge 111 and the third edge 113, and the first interconnect 410 disposed adjacent to the first beveled edge 121, wherein the first interconnect 410 is connected with at least one first finger 200 or at least one second finger 300, the intersection point between the first beveled edge 121 and the first edge 111 is the first intersection point J2, the intersection point between the first beveled edge 121 and the third edge 113 is the second intersection point J1, the distance between the first intersection point J2 and the second intersection point J1 is less than or equal to 2.5 mm, and the number of first fingers 200 or second fingers 300 connected with the first interconnect 410 is less than or equal to four. By the above settings, the first beveled edge 121 can be made very small, so that the first interconnect 410 located at the first beveled edge 121 is shorter, and only less than or equal to four first fingers 200 or second fingers 300 can be connected, so that the light-receiving area of a cell is ensured as much as possible, and the conversion efficiency of the cell is ensured.

In some optional embodiments, the first beveled edge 121 is a straight line or an arc.

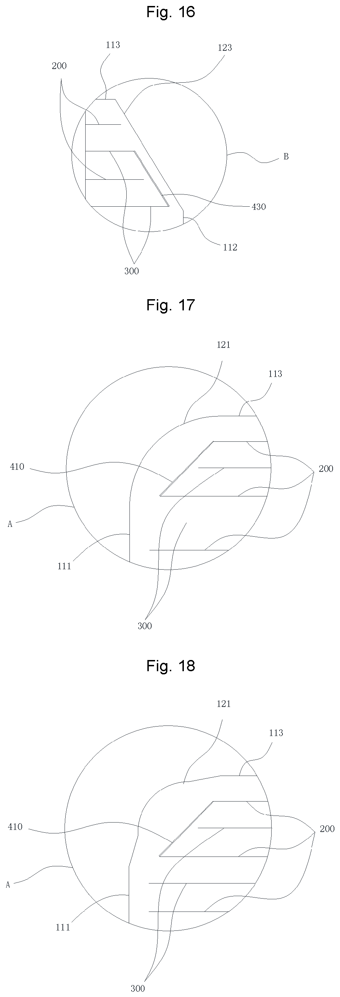

During implementation, each beveled edge can be a straight line, and the first beveled edge 121 is taken as an example, as shown in Fig. 14, Fig. 15 and Fig. 16. In some possible embodiments, each beveled edge can also be an arc, and the first beveled edge 121 is used as an example, as shown in Fig. 17. Of course, each beveled edge can also be a combination of a straight line and an arc, as shown in Fig. 18.

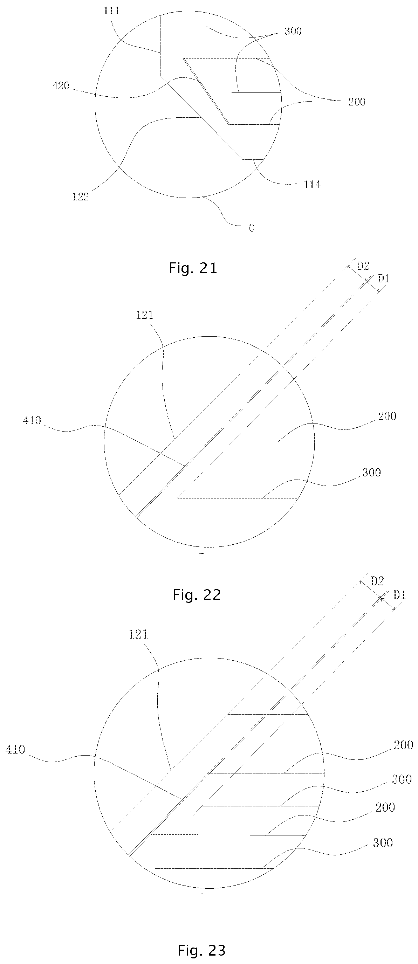

In some optional embodiments, the interconnect is not parallel to the corresponding beveled edge, for example, the first interconnect 410 is not parallel to the first beveled edge 121, the second interconnect 420 is not parallel to the second beveled edge 122, the third interconnect 430 is not parallel to the third beveled edge 123, and the fourth interconnect 440 is not parallel to the fourth beveled edge 124, as shown in Fig. 21, and no repeated description will be given.

In some optional embodiments, the first interconnect 410 includes a first connection portion 450 and a second connection portion 460, the first connection portion 450 is used for connecting two fingers having the same polarity, and the second connection portion 460 is connected with the first connection portion 450.

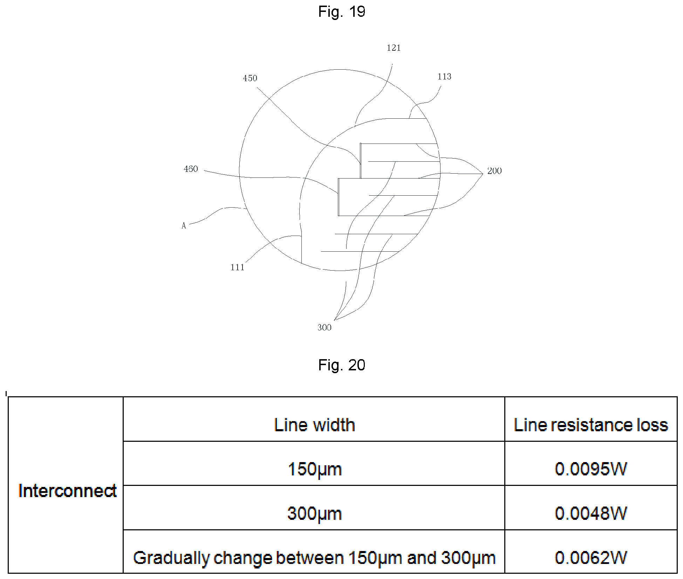

The entire interconnect can be designed to a step shape, shown in Fig. 19, exemplarily, it is taken as an example that the first interconnect 410 is connected with the first finger 200 and the second interconnect 420 is connected with the second finger 300, the first fine gate of the first finger 200, the first fine gate of the second finger 300, the second fine gate of the first finger 200, the second fine gate of the second finger 300, ....., the Nth first finger 200 and the Nth second finger 300 are sequentially distributed from top to bottom on the silicon wafer 100. A first end of the first connection portion 450 of the first interconnect 410 is connected with the first fine gate of the first finger 200, a second end of the first connection portion 450 of the first interconnect 410 is connected with the second fine gate of the first finger 200, and the second connection portion 460 of the first interconnect 410 is perpendicular or substantially perpendicular to the first connection portion 450 of the first interconnect 410. Similarly, the first end of the first connection portion 450 of the second interconnect 420 is connected with the first fine gate of the second finger 300, the second end of the first connection portion 450 of the second interconnect 420 is connected with the second fine gate of the second finger 300, and the second connection portion 460 of the second interconnect 420 is perpendicular to or substantially perpendicular to the first connection portion 450 of the second interconnect 420.

During implementation, the second connection portion 460 and the first connection portion 450 are connected by one finger, optionally, the second connection portion 460 and the first connection portion 450 are parallel to the first direction, and optionally, the first connection portion 450 is an diagonal line. The first connection portion 450 and the second connection portion 460 are distributed in a current direction, that is, the first end of the first connection portion 450 is connected with the first fine gate of the first finger 200, the second end of the first connection portion 450 is connected with the second fine gate of the first finger 200, at this time, the current of the first fine gate of the first finger 200 flows through the first connection portion 450, the second connection portion 460 is connected with the first connection portion 450, at this time, the sum of the current of the first fine gate of the first finger 200 and the current of the second fine gate of the first finger 200 flows through the second connection portion 460, and by designing the width of the first connection portion 450 to be less than the width of the second connection portion 460, the line resistance (resistance) of the second connection portion 460 can be effectively reduced, thereby reducing the overall electric energy loss of the interconnects and improving the power generation efficiency of the solar cell.

In some optional embodiments, the width of the interconnect 400 is greater than the width of the finger, during implementation, the width of the interconnect 400 is related to the line resistance, generally, the greater the line width is, the smaller the line resistance is, and the interconnects with different line widths have different line resistance losses. For example, when the line width of the interconnect 400 is 150 µm, the line resistance loss is 0.0095 W. When the line width of the interconnect 400 is 300 µm, the line resistance loss is 0.0048 W. When the line width of the interconnect 400 gradually changes, for example, when the width of the interconnect 400 gradually changes from 150 µm to 300 µm, the line resistance loss is 0.0062 W, as shown in Fig. 20. Therefore, the line resistance of the interconnect 400 can be effectively reduced by using the interconnect 400 with a greater width, thereby reducing the loss of the current flowing through the interconnect 400.

Optionally, the line resistance of the interconnect 400 can be effectively reduced by using a large-width design of the interconnect 400, but if the line width of the interconnect 400 is relatively large, the light-receiving area of the solar cell is blocked, resulting in a reduction in the power generation efficiency of the solar cell, at this time, a ratio of the width of the finger to the width of the interconnect 400 can be designed to be 1 : 1.2 to 1: 2, for example, the ratio of the width of the finger to the width of the interconnect 400 can be designed to be 1: 1.3, 1: 1.5 or 1: 1.9, and the like. Preferably, the ratio of the width of the finger to the width of the interconnect 400 is 1: 1.6 to 1: 1.8, for example, the ratio of the width of the finger to the width of the interconnect 400 can be designed to be 1: 1.7, or 1: 1.75, and the like, which is not limited. By the above settings, the line resistance of the interconnect 400 and the power generation efficiency of the solar cell can be effectively considered.

In some optional embodiments, an included angle between the first interconnect 410 and the second direction is greater than an included angle between the third interconnect 420 and the second direction, and similarly, an included angle between the second interconnect 420 and the second direction is greater than an included angle between the fourth interconnect 440 and the second direction.

During implementation, the second direction refers to a direction parallel to the finger, it is taken as an example that the first fingers 200 and the second fingers 300 are alternately arranged in the longitudinal direction, the second direction is the transverse direction, that is, the first fingers 200 and the second fingers 300 extend in the transverse direction. Exemplarily, it is taken as an example that the included angle between the first interconnect 410 and the second direction is Z1, and the included angle between the third interconnect 430 and the second direction is Z2, then Z1 > Z2. Similarly, the included angle between the second interconnect 420 and the second direction is Z3, and the included angle between the fourth interconnect 440 and the second direction is Z4, then Z3 > Z4.

In some optional embodiments, both the first interconnect 410 and the second interconnect 420 are connected with the first finger 200, and both the third interconnect 430 and the fourth interconnect 440 are connected with the second finger 300;
in the second direction, when the first interconnect 410 is connected with the first finger 200, the distance between the end point of the second finger 300 adjacent to the first interconnect 410 and the first interconnect 410 is less than the distance between the first interconnect 410 and the first beveled edge 121; or, when the first interconnect 410 is connected to the second finger 300, the distance between the end point of the first finger 200 adjacent to the first interconnect 410 and the first interconnect 410 is less than the distance between the first interconnect 410 and the first beveled edge 121.

Optionally, it is taken as an example that the first interconnect 410 is connected with the first fine gate of the first finger 200, as shown in Fig. 22, at this time, the first interconnect 410 and the second finger 300 are spaced apart, the distance between the first interconnect 410 and an end portion of the second finger 300 is regarded as D1, and the distance between the first interconnect 410 and the first beveled edge 121 is regarded as D2, then D1 < D2.

In some possible embodiments, when the interconnects and the plurality of fingers are spaced apart, it is taken as an example that the first fine gate of the first finger 200, the first fine gate of the second finger 300, the second fine gate of the first finger 200 and the second fine gate of the second finger 300 are sequentially distributed from top to bottom, as shown in Fig. 23. The first interconnect 410 is connected with the first fine gate of the first finger 200 and the second fine gate of the first finger 200, at this time, the first interconnect 410 is spaced apart from the first fine gate of the second finger 300 and the second fine gate of the second finger 300, and the finger closest to the interconnect is selected to confirm the distance. For example, when the distance between the first interconnect 410 and the end portion of the first fine gate of the second finger 300 is less than the distance between the first interconnect 410 and the end portion of the second fine gate of the second finger 300, the distance between the first interconnect 410 and the end portion of the first fine gate of the second finger 300 is regarded as D1, and the distance between the first interconnect 410 and the first beveled edge 121 is regarded as D2, then D1 < D2.

Similarly, in some other embodiments, the second interconnect 420, the third interconnect 430 and the fourth interconnect 440 can refer to the design of the first interconnect 410, therefore no repeated description will be given.

In some optional embodiments, in the second direction, the distance between the first interconnect 410 and the first beveled edge 121 is greater than the distance between the third interconnect 430 and the third beveled edge 123.

It is taken as an example that the second direction is the transverse direction, the first beveled edge 121 is located at a top left corner of the silicon wafer 100, the second beveled edge 122 is located at a lower left corner of the silicon wafer 100, the third beveled edge 123 is located at a top right corner of the silicon wafer 100, and the fourth beveled edge 124 is located at a lower right corner of the silicon wafer 100. The distance between the first interconnect 410 and the edge of the first beveled edge 121 is greater than the distance between the third interconnect 430 and the edge of the third beveled edge 123, and similarly, the distance between the second interconnect 420 and the edge of the second beveled edge 122 is greater than the distance between the fourth interconnect 440 and the edge of the fourth beveled edge 124.

Optionally, the interconnect is not parallel to the corresponding beveled edge, for example, the first interconnect 410 is not parallel to the first beveled edge 121, similarly, the second interconnect 420 is not parallel to the second beveled edge 122, and the situations of the third interconnect 430 and the fourth interconnect 440 are similar, therefore no repeated description will be given. A point on the beveled edge closest to the interconnect can be selected to confirm the distance, taking the first interconnect 410 as an example, the distance between an upper end point of the first interconnect 410 and the first beveled edge 121 is greater than the distance between a lower end point of the first interconnect 410 and the first beveled edge 121, and the distance between the lower end point of the first interconnect 410 and the first beveled edge 121 is regarded as the distance between the first interconnect 410 and the first beveled edge 121. Of course, an average value of the distances between the two ends of the first interconnect 410 and the first beveled edge 121 can also be selected as the distance between the first interconnect 410 and the first beveled edge 121, and no repeated description will be given.

In some optional embodiments, the first interconnect 410 is connected to the first finger 200, the third interconnect 430 is connected to the second finger 300, and in the second direction, the width of the first interconnect 410 is less than the width of the third interconnect 430; and similarly, the second interconnect 420 is connected to the first finger 200, the fourth interconnect 440 is connected to the second finger 300, and in the second direction, the width of the second interconnect 420 is less than the width of the fourth interconnect 440.

In some optional embodiments, the line width of the second finger 300 is greater than the line width of the first finger 200.

In some optional embodiments, it is taken as an example that the first direction is the longitudinal direction, then the second direction is the transverse direction, the second fingers 300 and the first fingers 200 are alternately distributed on the silicon wafer 100 in the first direction, so that the first fingers 200 and the second fingers 300 are symmetrically distributed up and down, exemplarily, when the first fingers 200 are closest to the third edge 113, the first fingers are also closest to the fourth edge 114. In addition, the first fingers 200 and the second fingers 300 are asymmetric on left and right.

### Embodiment 3

In some optional embodiments, the present disclosure provides a photovoltaic module, including the solar cell as described above.

The photovoltaic module is composed of at least one solar cell, the first fingers 200 in the solar cell are connected by a positive-electrode ribbon 500, the second fingers 300 are by a negative-electrode ribbon 600, the ribbons of the adjacent solar cells can be connected in series or in parallel, and no repeated description will be given.

It can be clearly understood by those skilled in the art to which the present disclosure belongs that, for the convenience and conciseness of description, regarding the structures and implementation principles of the photovoltaic module described above, reference can be made to corresponding structures and implementation principles in the foregoing Embodiment 1, and thus details are not described herein again.

The solar cell of the present disclosure includes the silicon wafer 100 and the fingers disposed on the silicon wafer 100, the fingers include the first fingers 200 and the second fingers 300 alternately distributed in the first direction, the silicon wafer 100 has the first fine gate of the first edge 111 and the second edge 112 disposed opposite to each other in the second direction, the third edge 113 and the fourth edge 114 disposed opposite to each other in the first direction, the second direction being perpendicular to the first direction, the first beveled edge 121 for connecting the first edge 111 and the third edge 113, and the first interconnect 410 disposed adjacent to the first beveled edge 121, wherein the first interconnect 410 is connected with at least one first finger 200 or at least one second finger 300, the intersection point between the first beveled edge 121 and the first edge 111 is the first intersection point J2, the intersection point between the first beveled edge 121 and the third edge 113 is the second intersection point J1, the distance between the first intersection point J2 and the second intersection point J1 is less than or equal to 2.5 mm, and the number of first fingers 200 or second fingers 300 connected with the first interconnect 410 is less than or equal to four. By means of the above settings, the first beveled edge 121 can be made very small, so that the first interconnect 410 located at the first beveled edge 121 is shorter, and only less than or equal to four first fingers 200 or second fingers 300 can be connected, so that the light-receiving area of a cell is ensured as much as possible, and the conversion efficiency of the cell is ensured.

The above description are only preferred embodiments of the present disclosure and are not intended to limit the present disclosure, and any modifications, equivalent replacements, improvements, and the like, made within the spirit and principles of the present disclosure, shall fall within the protection scope of the present disclosure.

## Claims

1. A solar cell, comprising:
a silicon wafer, wherein several fingers are disposed on the silicon wafer, and the fingers comprise first fingers and second fingers alternately distributed in a first direction;
the silicon wafer comprises:
a first edge and a second edge disposed opposite to each other in a second direction, and a third edge and a fourth edge disposed opposite to each other in the first direction, the second direction being perpendicular to the first direction;
a first beveled edge for connecting the first edge and the third edge; and
a first interconnect disposed adjacent to the first beveled edge, wherein the first interconnect is connected with at least one first finger or at least one second finger; and
an intersection point between the first beveled edge and the first edge is a first intersection point, an intersection point between the first beveled edge and the third edge is a second intersection point, a distance between the first intersection point and the second intersection point is less than or equal to 2.5 mm, and the number of the first fingers or the second fingers connected with the first interconnect is less than or equal to four.

2. The solar cell according to claim 1, wherein the first beveled edge is a straight line or an arc.

3. The solar cell according to claim 2, wherein the first interconnect is not parallel to the first beveled edge.

4. The solar cell according to any of claims 1-2, wherein the first interconnect comprises a first connection portion and a second connection portion, and a width of the first connection portion is less than a width of the second connection portion.

5. The solar cell according to claim 4, wherein the first connection portion is connected with the second connection portion, and the first connection portion is an diagonal line.

6. The solar cell according to claim 4, wherein the second connection portion and the first connection portion are connected by one finger.

7. The solar cell according to claim 6, wherein the second connection portion and the first connection portion are parallel to the first direction.

8. The solar cell according to claim 4, wherein a ratio of a width of the finger to a width of the first interconnect is 1: 1.2 to 1: 2.

9. The solar cell according to claim 8, wherein the ratio of the width of the finger to the width of the first interconnect is 1: 1.6 to 1: 1.8.

10. The solar cell according to claim 1, wherein the distance between the first intersection point and the second intersection point is 0.7 mm to 2.5 mm.

11. The solar cell according to claim 10, wherein the distance between the first intersection point and the second intersection point is 1.2 mm to 1.6 mm.

12. The solar cell according to claim 1, wherein the silicon wafer comprises a second beveled edge for connecting the first edge and the fourth edge;
a second interconnect adjacent to the second beveled edge is disposed on the silicon wafer, and the second interconnect is connected with at least one first finger or at least one second finger; and
the first interconnect and the second interconnect are connected to fingers having a same polarity.

13. The solar cell according to claim 12, wherein the silicon wafer comprises a third beveled edge for connecting the second edge and the third edge;
a third interconnect adjacent to the third beveled edge is disposed on the silicon wafer, and the third interconnect is connected with at least one first finger or at least one second finger; and
the first interconnect and the third interconnect are connected to fingers having opposite polarities.

14. The solar cell according to claim 13, wherein an included angle between the first interconnect and the second direction is greater than an included angle between the third interconnect and the second direction.

15. The solar cell according to claim 1, wherein the first interconnect is connected to the first finger, and in the second direction, a distance between an end point of the second finger adjacent to the first interconnect and the first interconnect is less than a distance between the first interconnect and the first beveled edge; or
the first interconnect is connected to the second finger, and in the second direction, a distance between an end point of the first finger adjacent to the first interconnect and the first interconnect is less than the distance between the first interconnect and the first beveled edge.

16. The solar cell according to claim 13, wherein in the second direction, the distance between the first interconnect and the first beveled edge is greater than a distance between the third interconnect and the third beveled edge.

17. The solar cell according to claim 13, wherein the first interconnect is connected to the first finger, and the third interconnect is connected to the second finger; and
in the second direction, the width of the first interconnect is less than a width of the third interconnect.

18. The solar cell according to claim 1, wherein a width of the second finger is greater than a width of the first finger.

19. A photovoltaic module, comprising the solar cell according to any of claims 1-18.
